# EUROPEAN PATENT SPECIFICATION

(11) **EP 1 528 434 B1**
(45) Date of publication and mention of the grant of the patent: **08.03.2006**
(21) Application number: 04256586.1
(22) Date of filing: 26.10.2004
(51) Int. Cl.: G03F 7/20

(54) **Lithographic apparatus and device manufacturing method**
Lithographischer Apparat und Verfahren zur Herstellung einer Vorrichtung
Appareil lithographique et méthode de fabrication d'un dispositif

(30) Priority: 30.10.2003 EP 03256893
(43) Date of publication of application: 04.05.2005
(73) Proprietor: ASML Netherlands B.V., 5504 DR Veldhoven (NL)
(72) Inventor: Jasper, Johannes Christiaan Maria, 5507 RD Veldhoven (NL)
(74) Representative: Leeming, John Gerard

(56) References cited:
- EP-A- 1 160 627
- WO-A-03/036695
- PATENT ABSTRACTS OF JAPAN vol. 1998, no. 03, 27 February 1998 (1998-02-27) & JP 9 306825 A (CANON INC), 28 November 1997 (1997-11-28)

## Description

The present invention relates to a lithographic apparatus and a device manufacturing method.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

In a lithographic apparatus, the size of features that can be imaged is limited by the wavelength of the exposure radiation used. Therefore, to be able to image finer details, it is necessary to use radiation of shorter wavelength. Current production lithographic apparatus use ultraviolet radiation at 248nm or 193nm. Apparatus using radiation at 157nm are under development. One of the issues that must be overcome in a lithographic apparatus using 157nm radiation is that ordinary atmospheric air is substantially opaque at that wavelength. Therefore it is proposed to purge the lithographic apparatus, or at least the beam path, with extremely pure nitrogen (N₂). The degree of purity required is very high, even a few parts per million (ppm) of oxygen or water vapor will cause a significant reduction in the transmission of the exposure radiation. Use of such high purity nitrogen presents two problems - it is expensive and it is hazardous to the personnel operating or servicing the apparatus.

To alleviate these problems, it has been proposed that the purge system have two modes, a high-flow mode for exposures and a low-flow mode for use when the apparatus is not in use and particularly when a compartment of the apparatus has been opened, e.g. for servicing. The low-flow mode has a flow rate that is just sufficient to protect the optical elements in the apparatus from contamination that might occur on exposure to the normal atmosphere but is not hazardous to humans. When the apparatus is to be restarted after a period in low-flow purge mode, it takes some time, of the order of 15-30 minutes in high-flow purge mode to purge the beam path so that production can recommence. This time is required to ensure a uniform gas mixture in the beam path and hence a uniform dose across the exposure field. Because optical elements in the apparatus can be damaged if the exposure radiation source is turned on whilst contaminants are present, it is necessary to leave some margin for error - known O₂ and water sensors cannot reliably detect the levels of contamination that might causes damage - and therefore there may be a delay of as much as 30-60mins each time a compartment of the apparatus is opened before production can recommence. Such downtime seriously reduces the throughput of the apparatus.
WO 03/036695 A discloses a lithographic apparatus with purge means operable in a high flow rate mode and a low flow rate mode.

It is an object of the present invention to provide a lithographic apparatus and device manufacturing method in which production can be recommenced more quickly after a period of less than full flow purging.

According to an aspect of the invention, there is provided a lithographic apparatus according to claim 1.

By using a sensor to monitor the intensity of the projection beam downstream, with respect to the direction of the projection beam, of the purged compartment, a highly sensitive contamination detector is effected, enabling the apparatus to return to production mode as soon as contamination levels have returned to specification for production. At the same time, using only a low intensity prevents damage to the optical elements of the apparatus in the presence of contaminants.

The predetermined criterion may be that the intensity of the beam has reached a level indicative that the transmission of the beam path has returned to the level required for production, e.g. 99% or higher transmission. During the low-flow, second purge mode, the transmission of the beam path may be about 60% of the transmission during high-flow purging and after contaminants have been cleared.

In a preferred embodiment of the invention, the predetermined criterion is that the variation in transmission of the beam path is less than a predetermined threshold, e.g. 1%. When the transmission is that stable, it can be assumed that the purge conditions are that stable. This arrangement avoids the need to provide a sensor with a high absolute accuracy over a long period of time, as is required if intensity levels before and after a downtime period are to be compared.

Preferably, the energy sensor is spatially sensitive and the predetermined criterion is that the beam intensity across at least a part of its cross-section has a predetermined uniformity. By considering the uniformity of the beam intensity rather than its absolute intensity, any variations in its intensity caused by fluctuations in source output are disregarded.

Where the projection beam is pulsed, the predetermined criterion may refer to a measurement averaged over several pulses. Again, pulse-to-pulse variations in source output are disregarded.

The intensity of the beam may be reduced by operating a pulsed radiation source at a lower pulse repetition rate, e.g. 1Hz, than that used during production, e.g. 4kHz, and/or by using a variable attenuator in said illumination system.

According to a further aspect of the invention, there is provided a device manufacturing method according to claim II.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:
- Figure 1 depicts a lithographic apparatus according to an embodiment of the invention;
- Figure 2 depicts the purge gas arrangements and associated control system of the apparatus of Figure 1.

### EMBODIMENTS

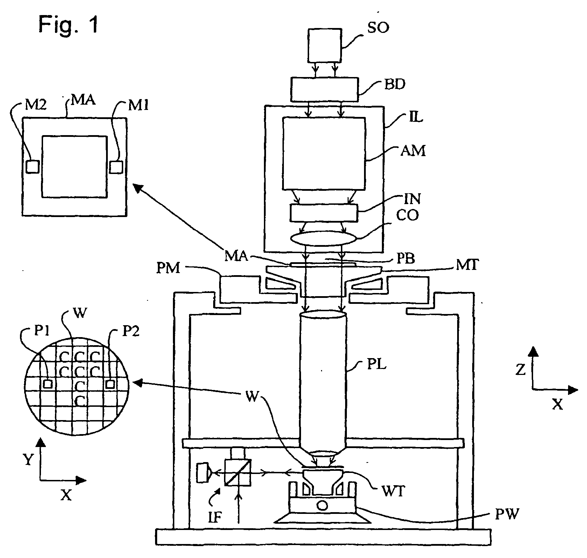

Figure 1 schematically depicts a lithographic apparatus according to a particular embodiment of the invention. The apparatus comprises:
- an illumination system (illuminator) IL for providing a projection beam PB of radiation (e.g. DUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a refractive projection lens) PL for imaging a pattern imparted to the projection beam PB by patterning means MA onto a target portion C (e.g. comprising one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The projection beam PB is incident on the mask MA, which is held on the mask table MT. Having traversed the mask MA, the projection beam PB passes through the lens PL, which focuses the beam onto a target portion C of the substrate W. With the aid of the second positioning means PW and position sensor IF (e.g. an interferometric device), the substrate table WT can be moved accurately, e.g. so as to position different target portions C in the path of the beam PB. Similarly, the first positioning means PM and another position sensor (which is not explicitly depicted in Figure 1) can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

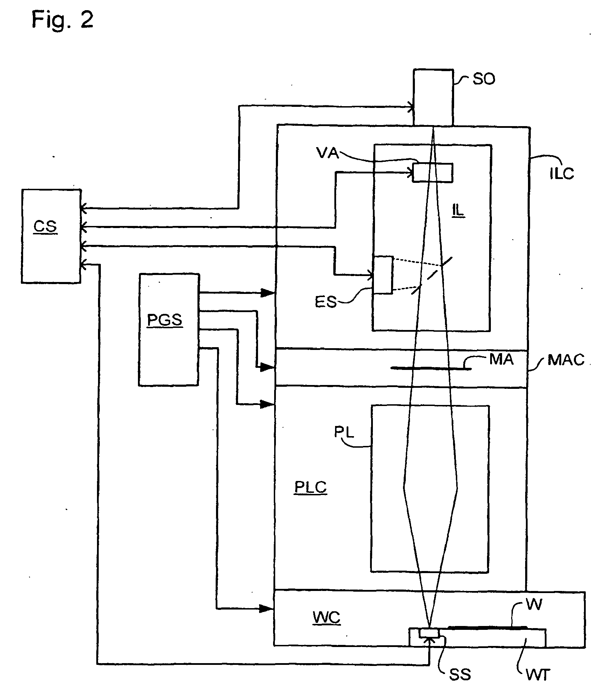

The purge gas arrangements of the apparatus and associated control system are shown in Figure 2. The apparatus is divided in to a number of compartments, in this case four are shown - the illumination system compartment ILC, the mask compartment MAC, the projection system compartment PLC and the substrate compartment WC. To each compartment, purge gas is supplied from purge gas supply system PGS. In the case of an apparatus using exposure radiation of wavelength 157nm or thereabouts, the purge gas is extremely pure N₂ to displace the air from the beam path, which would otherwise block the transmission of the exposure radiation.

The purge gas supply system operates in two modes, a high-flow mode for the exposure of substrates and a low-flow mode which is used when a compartment of the apparatus is open and/or during other down time of the apparatus. The low-flow mode consumes less of the purge gas, which is expensive due to its high purity, and is less hazardous to humans. Nevertheless, the flow is sufficient to protect the optical elements from contamination and prevent a build-up of contaminants in the apparatus. The actual flow rates in the high- and low-flow modes will depend on the sizes of the various compartments as well as the leaks and other possible contamination sources within them. The flow rate in high-flow mode is generally three to four times that in low-flow mode. This factor may vary from apparatus to apparatus and from compartment to compartment. If not all compartments are to be opened, the compartments remaining closed may remain in high-flow mode.

After having operated in the low-flow mode for a period of time, it must be ensured that the contaminant levels in the beam path have returned to specified levels before exposures can begin, lest the optical elements in the projection and illumination systems be damaged by a reaction with a contaminant under the influence of the powerful projection beam.

When the high-flow mode is resumed, the control system CS controls the radiation source SO to emit a low power beam and monitors the beam intensity at substrate level using a spot sensor SS built into the substrate table WT. When the measured intensity indicates a return to normal transmission levels, production exposures using a full power projection beam may resume. Since the transmission of the atmosphere in the beam path is extremely sensitive to the contaminants that can damage the optical elements, principally oxygen and water vapor, the transmission returning to normal indicates that the beam path is contaminant free. Contamination of only 1-10ppm can cause a distinct drop in transmission.

Various criteria may be used to determine whether the transmission is at normal levels, including:
1. the absolute intensity exceeding a threshold,
2. the rate of change of intensity falling below a threshold
3. the uniformity of intensity across the cross-section of the projection beam exceeding a threshold, e.g. non-uniformity <0.2%;
4. the stability of the intensity over time exceeding a threshold, e.g. variation < 5%, preferably < 2%, most preferably <1%.

In all of the above criteria, time averages of the relevant parameters may be employed.

Where the source SO is a pulsed source, e.g. an excimer laser, the intensity of the projection beam may be reduced by reducing the pulse repetition rate, e.g. to <10 Hz, preferably about lHz compared to a normal rate for exposures of 4kHz or more. The intensity of the projection beam may also be controlled using a variable attenuator VA in the illumination system IL.

If the illumination system incorporates an energy sensor to which a proportion of the projection beam is directed, e.g. by a partly silvered mirror, the output of the energy sensor may also be taken into account, e.g. as a reference to enable variations in the source output to be compensated for. Also, if the only compartment which has been in the low-flow mode is up-beam of the energy sensor, the beam intensity measured by the energy sensor may be used in place of the intensity measured by the spot sensor.

While specific embodiments of the invention have been described above, it will be appreciated that the invention may be practiced otherwise than as described. The description is not intended to limit the invention which is defined by the claims.

## Claims

1. A lithographic apparatus comprising:
- an illumination system (IL) for providing a projection beam (PB) of radiation;
- a support structure (M, T) for supporting patterning means (MA) the patterning means serving to impart the projection beam (PB) with a pattern in its cross-section;
- a substrate table (WT) for holding a substrate (W);
- a projection system (PL) for projecting the patterned beam onto a target portion (C) of the substrate (W);
purge means (PGS) for purging at least a part of the apparatus with a purge gas, the purge means (PGS) being operable in a first mode having a relatively high flow of purge gas and a second mode having a relatively low flow of purge gas; and
a sensor (SS) arranged to a measure the intensity of said projection beam at a position downstream, with respect to the direction of the projection beam, of a part of said apparatus, said part being a part that is purged by said purge means; **characterized by**:
a control device (CS) arranged to control said illumination system (IL) to generate a projection beam at an intensity lower than a normal intensity used to expose target portions of said substrate in response to a change in mode of said purge means from said second mode to said first mode and arranged to monitor the intensity of said projection beam as measured by said sensor, said control device being arranged to prevent said illumination system from generating a projection beam having said normal intensity until said intensity of said projection beam as measured by said sensor meets a predetermined criterion.

2. Apparatus according to claim 1 wherein said predetermined criterion is that the intensity of the beam has reached a level indicative that the transmission of the beam path has returned to the level required for production.

3. Apparatus according to claim 1 wherein said predetermined criterion is that the rate of change of intensity of the beam has fallen below a predetermined threshold.

4. Apparatus according to claim 1 wherein said sensor (SS) is spatially sensitive and said predetermined criterion is that the beam intensity across at least a part of its cross-section has a predetermined uniformity.

5. Apparatus according to claim 1 wherein said predetermined criterion is that the stability of the transmission of the beam path over time is less than a predetermined threshold.

6. Apparatus according to any one of the preceding claims wherein said predetermined criterion is based upon a time average of the intensity of said projection beam or the rate of change thereof.

7. Apparatus according to any one of the preceding claims wherein said illumination system (IL) provides a pulsed projection beam and said control device controls said illumination system (IL) to provide a pulsed beam having a lower pulse repetition rate than that used during production as said projection beam of lower intensity.

8. Apparatus according to any one of the preceding claims wherein said control device controls a variable attenuator in said illumination system to generate said projection beam of reduced intensity.

9. Apparatus according to any one of the preceding claims wherein said projection beam of reduced intensity has an intensity of less than or equal to 1% of said normal intensity.

10. Apparatus according to any one of the preceding claims wherein said sensor (SS) is provided on said substrate table (WT).

11. A device manufacturing method comprising the steps of
- first purging at least a part of the beam path traversed by a projection beam with a purge gas at a first flow rate; and then
second purging said part of the beam path traversed by said projection beam with a purge gas at a second flow rate higher than said first flow rate;
**characterized by**:
directing a projection beam (PB) at a first intensity along said beam path during said step of second purging;
monitoring the transmission of the projection beam (PB) in at least said part of the beam path; and
only after the transmission of the projection beam (PB) in said beam path has met a predetermined criterion, directing a projection beam (PB) at a second intensity higher than said first intensity along said beam path to expose a target portion (C) of a substrate (W).

## Patentansprüche

1. Lithographievorrichtung, folgendes aufweisend:
- ein Beleuchtungssystem (IL) zum Bereitstellen eines Projektionsstrahls (PB) aus Strahlung;
- eine Abstützung (MT) zum Abstützen einer Mustereinrichtung (MA), wobei die Mustereinrichtung dazu dient, den Projektionsstrahl (PB) über seinen Querschnitt mit einem Muster zu versehen;
- einen Substrattisch (WT) zum Halten eines Substrates (w);
- ein Projektionssystem (PL) zum Projizieren des gemusterten Strahls auf einen Zielabschnitt (C) des Substrates (w);
- eine Spüleinrichtung (PG5) zum Spülen von zumindest einem Teil der Vorrichtung mit einem Spülgas, wobei die Spüleinrichtung (PG5) in einer ersten Betriebsart betreibbar ist mit einer relativ starken Strömung des Spülgases und in einer zweiten Betriebsart mit einer relativ geringen Strömung des Spülgases; und mit
einem Sensor, der angeordnet ist, die Intensität des genannten Projektionsstrahls an einer strahlabwärts in Bezug auf die Richtung des Projektionsstrahls gelegenen Stelle zu messen, und zwar bei einem Teil der Vorrichtung, wobei dieser Teil durch das Spülgas gespült ist, **gekennzeichnet durch**
eine Steuereinrichtung (CS), die angeordnet ist, das genannte Beleuchtungssystem zu steuern, um einen Projektionsstrahl mit einer Intensität zu erzeugen, die geringer ist als eine Normalintensität, die verwendet wird, um die Zielabschnitte des Substrates bei einem Wechsel der Betriebsart der Spüleinrichtung von der zweiten Betriebsart in die erste Betriebsart zu erzeugen, und um die Intensität des Projektionsstrahls, wie sie von dem Sensor gemessen wird, zu beobachten, wobei die genannte Steuereinrichtung angeordnet ist, das Beleuchtungssystem daran zu hindern, einen Projektionsstrahl mit der genannten Normalintensität zu erzeugen bis die genannten Intensität des Projektionsstrahls, wie sie mit den genannten Sensor gemessen wird, ein vorgegebenes Maß erreicht.

2. Vorrichtung gemäß Anspruch 1, wobei das vorgegebene Maß bedeutet, dass die Intensität des Strahls einen Wert erreicht, der anzeigt, dass die Transmission des Strahlweges einen Wert erreicht, der für die Produktion erforderlich ist.

3. Vorrichtung gemäß Anspruch 1, wobei das vorgegebene Maß darin besteht, dass die Änderungsgeschwindigkeit der Intensität des Strahls unter einen vorgegebenen Schwellenwert abgefallen ist.

4. Vorrichtung gemäß Anspruch 1, wobei der genannte Sensor (SS) räumlich empfindlich ist und das genannte vorgegebene Maß darin besteht, dass die Strahlintensität über zumindest einen Teil seines Querschnittes eine vorgegebene Gleichförmigkeit hat.

5. Vorrichtung gemäß Anspruch 1, wobei das vorgegebene Maß darin besteht, dass die Stabilität der Transmission des Strahlweges in Abhängigkeit von der Zeit besser ist als ein vorgegebener Schwellenwert.

6. Vorrichtung gemäß einem der vorangehenden Ansprüche, wobei das genannte vorgegebene Maß auf einem zeitlichen Mittelwert der Intensität des Projektionsstrahls oder der Änderungsrate desselben beruht.

7. Vorrichtung gemäß einem der vorhergehenden Ansprüche, wobei das genannte Beleuchtungssystem (IL) einen gepulsten Projektionsstrahl bereitstellt und die genannte Steuereinrichtung das genannte Beleuchtungssystem (IL) so steuert, dass ein gepulster Strahl bereitgestellt wird mit einer geringeren Repetitionsrate als diejenige, die bei der Produktion eingesetzt wird, da der genannte Projektionsstrahl geringere Intensität hat.

8. Vorrichtung nach einem der vorhergehenden Ansprüche, wobei die genannte Steuereinrichtung einen variablen Abschwächer in dem genannten Beleuchtungssystem steuert, um einen Projektionsstrahl reduzierter Intensität zu erzeugen.

9. Vorrichtung gemäß einem der vorhergehenden Ansprüche, wobei der genannte Projektionsstrahl verringerter Intensität eine Intensität kleiner/gleich 1% der genannten Normalintensität hat.

10. Vorrichtung gemäß einem der vorhergehenden Ansprüche, wobei der genannte Sensor (SS) auf dem genannten Substrattisch (WT) angeordnet ist.

11. Verfahren zum Herstellen eines Produktes mit folgenden Schritten:
- anfängliches Spülen von zumindest einem Teil eines Strahlweges, den ein Projektionsstrahl durchläuft, mit einem Spülgas mit einer ersten Strömungsgeschwindigkeit; und sodann
- ein nachfolgendes Spülen des genannten Teils des Strahlungsweges, durch den der genannte Projektionsstrahl läuft, mit einem Spülgas mit einer zweiten Strömungsgeschwindigkeit, die größer ist als die erste Strömungsgeschwindigkeit;
**gekennzeichnet durch**
Richten eines Projektionsstrahls (PB) einer ersten Intensität entlang dem Strahlungsweg während des genannten Schrittes des nachfolgenden Spülens;
Beobachten der Transmission des Projektionsstrahls (PB) in zumindest einem Teil des Strahlungsweges; und
Richten eines Projektionsstrahls (PB) mit einer zweiten Intensität, die höher ist als die genannte erste Intensität entlang dem Strahlweg, wenn die Transmission des Projektionsstrahls (PB) in dem genannten Strahlweg ein vorgegebenes Maß erreicht hat, um einen Zielabschnitt (c) eines Substrates (w) zu belichten.

## Revendications

1. Appareil lithographique comprenant :
- un système d'illumination (IL) pour fournir un faisceau de projection (PB) de rayonnement ;
- une structure de support (MT) pour supporter des moyens de mise en forme (MA), les moyens de mise en forme servant à doter le faisceau de projection (PB) d'un motif dans sa section transversale ;
- une table de substrat (WT) pour porter un substrat (W) ;
- un système de projection (PL) pour projeter le faisceau mis en forme sur une partie cible (C) du substrat (W) ;
des moyens de purge (PGS) pour purger au moins une partie de l'appareil avec un gaz de purge, les moyens de purge (PGS) étant actionnables dans un premier mode ayant un écoulement relativement élevé de gaz de purge et un second mode ayant un écoulement relativement faible de gaz de purge ; et
un capteur (SS) agencé pour mesurer l'intensité dudit faisceau de projection en une position en aval, par rapport à la direction du faisceau de projection, d'une partie dudit appareil, ladite partie étant une partie qui est purgée par lesdits moyens de purge ; **caractérisé par** :
un dispositif de commande (CS) agencé pour commander ledit système d'illumination (IL) pour générer un faisceau de projection à une intensité inférieure à une intensité normale utilisée pour exposer des parties cible dudit substrat en réponse à un changement de mode desdits moyens de purge dudit second mode audit premier mode et agencé pour surveiller l'intensité dudit faisceau de projection telle que mesurée par ledit capteur, ledit dispositif de commande étant agencé pour empêcher ledit système d'illumination de générer un faisceau de projection ayant ladite intensité normale jusqu'à ce que ladite intensité dudit faisceau de projection telle que mesurée par ledit capteur satisfasse à un critère prédéterminé.

2. Appareil selon la revendication 1, dans lequel ledit critère prédéterminé est que l'intensité du faisceau a atteint un niveau indiquant que la transmission du trajet de faisceau est revenue au niveau requis pour la production.

3. Appareil selon la revendication 1, dans lequel ledit critère prédéterminé est que la vitesse de changement d'intensité du faisceau est tombée au-dessous d'un seuil prédéterminé.

4. Appareil selon la revendication 1, dans lequel ledit capteur (SS) est sensible spatialement et ledit critère prédéterminé est que l'intensité de faisceau à travers au moins une partie de sa section transversale a une uniformité prédéterminée.

5. Appareil selon la revendication 1, dans lequel ledit critère prédéterminé est que la stabilité de la transmission du trajet de faisceau dans le temps est inférieure à un seuil prédéterminé.

6. Appareil selon l'une quelconque des revendications précédentes, dans lequel ledit critère prédéterminé est basé sur une moyenne temporelle de l'intensité dudit faisceau de projection ou la vitesse de changement de celle-ci.

7. Appareil selon l'une quelconque des revendications précédentes, dans lequel ledit système d'illumination (IL) fournit un faisceau de projection pulsé et ledit dispositif de commande commande ledit système d'illumination (IL) pour fournir un faisceau pulsé ayant une vitesse de répétition d'impulsion inférieure à celle utilisée pendant la production en tant que dit faisceau de projection d'intensité inférieure.

8. Appareil selon l'une quelconque des revendications précédentes, dans lequel ledit dispositif de commande commande un atténuateur variable dans ledit système d'illumination pour générer ledit faisceau de projection d'intensité réduite.

9. Appareil selon l'une quelconque des revendications précédentes, dans lequel ledit faisceau de projection d'intensité réduite a une intensité inférieure ou égale à 1 % de ladite intensité normale.

10. Appareil selon l'une quelconque des revendications précédentes, dans lequel ledit capteur (SS) est prévu sur ladite table de substrat (WT).

11. Procédé de fabrication de dispositif comportant les étapes consistant à :
purger une première fois au moins une partie du trajet de faisceau traversé par un faisceau de projection avec un gaz de purge à un premier débit ; et ensuite
purger une seconde fois ladite partie du trajet de faisceau traversée par ledit faisceau de projection avec un gaz de purge à un second débit supérieur audit premier débit ;
**caractérisé par** :
la direction d'un faisceau de projection (PB) à une première intensité le long dudit trajet de faisceau pendant ladite étape de seconde purge ;
la surveillance de la transmission du faisceau de projection (PB) dans au moins ladite partie du trajet de faisceau ; et
la direction d'un faisceau de projection (PB) à une seconde intensité supérieure à ladite première intensité le long dudit trajet de faisceau pour exposer une partie cible (C) d'un substrat (W), seulement après que la transmission du faisceau de projection (PB) dans ledit trajet de faisceau a satisfait à un critère prédéterminé
